(19) Europäisches Patentamt
European Patent Office
Office européen des brevets

(11) Publication number: **0 378 103 A2**

(12) **EUROPEAN PATENT APPLICATION**

(21) Application number: **90100140.4**

(22) Date of filing: **04.01.90**

(51) Int. Cl.$^5$: **C08L 79/04, C08L 27/10, //(C08L79/04,27:10), (C08L27/10,79:04)**

(30) Priority: **11.01.89 US 295873**

(43) Date of publication of application: **18.07.90 Bulletin 90/29**

(84) Designated Contracting States: **AT BE CH DE ES FR GB IT LI NL SE**

(71) Applicant: **THE DOW CHEMICAL COMPANY**
**2030 Dow Center Abbott Road**
**Midland, MI 48640(US)**

(72) Inventor: **Monnerat, Georgia A.**
**303 Caladium**
**Lake Jackson Texas 77566(US)**

(74) Representative: **Sternagel, Hans-Günther, Dr. et al**
**Patentanwälte Dr. Michael Hann Dr. H.-G. Sternagel Sander Aue 30**
**D-5060 Bergisch Gladbach 2(DE)**

(54) **Cyanate ester resin blends with brominated styrene containingpolymers.**

(57) The fire retardant properties of polycyanates are improved by blending them with a brominated homopolymer or brominated interpolymer of styrene or alkyl- or halo-substituted styrene without an unacceptable sacrifice in the physical, thermal, electrical and moisture resistance properties.

EP 0 378 103 A2

# CYANATE ESTER RESIN BLENDS WITH BROMINATED STYRENE-CONTAINING POLYMERS

The present invention concerns blends of cyanate ester compounds and brominated polystyrene.

The present invention also concerns curable compositions containing such blends and articles resulting therefrom.

Cyanate ester resins are generally considered to be high performance thermosetting resins at least to the extent that they usually exhibit high glass transition temperatures. In some applications such as in electrical laminates and the like it is desirable that they exhibit high fire retardant properties in that it is desirable that they exhibit an Underwriters Laboratory test no. 94 rating of V-O. The current industry standard cyanate ester resin is based on bisphenol A. U.S. Patent 4,097,455 employs brominated cyanates to achieve flame resistance; however, this method can be very expensive.

It would be desirable to have available, a cyanate ester resin composition which has excellent flame resistance without an unacceptable sacrifice in the physical, thermal, electrical and moisture resistance properties which renders these cyanate ester resins desirable in such applications and at the same time be reasonably affordable in terms of cost.

The present invention pertains to a blend comprising (A) at least one compound containing a plurality of -OCN groups; and (B) a brominated homopolymer or brominted interpolymer of styrene or alkyl- or halo-substituted styrene or any combination thereof; wherein components (A) and (B) are present in an amount such that the blend contains a bromine content of from 4 to 25 percent by weight based on the combined weight of components (A) and (B).

Another aspect of the present invention pertains to a curable composition comprising the aforementioned blend and a curing amount of a suitable curing agent therefor.

Another aspect of the present invention pertains to an article resulting from curing the aforementioned curable composition.

The present invention provides a cyanate ester resin composition which has excellent flame resistance without an unacceptable sacrifice in the physical, thermal, electrical and moisture resistance properties which renders these cyanate ester resins desirable in electrical laminate and encapsulation applications and at the same time be reasonably affordable in terms of cost. In some instances, one or more of the properties are actually improved.

Suitable brominated polymers which can be employed herein include, for example the brominated homopolymers and brominated interpolymers of styrene, halo- or alkyl-substituted styrene, said alkyl groups having from 1 to 10 carbon atoms. Particularly suitable brominated polymers include, for example, brominated homopolymers or brominated interpolymers of styrene, o-methylstyrene, m-methylstyrene, p-methylstyrene, 2,4-dimethylstyrene, 2,5-dimethylstyrene p-tert-butylstyrene, p-chlorostyrene, $\alpha$-methylstyrene and combinations thereof.

The brominated polymers which can be employed herein include, for example, those which contain suitably from 24 to 70, more suitably from 50 to 68, most suitably from 60 to 68, percent bromine by weight; have a weight average molecular weight (Mw) suitably from 5,000 to 700,000, more suitably from 10,000 to 600,000, most suitably from 350,000 to 500,000; and a degree of polymerization (Dp) suitably from 25 to 3,000, more suitably from 50 to 2,500, most suitably from 1,400 to 2,400.

Suitable cyanate ester compounds employed in the present invention as the compound containing a plurality of -OCN groups are the cyanate esters of a hydrocarbon-aromatic hydroxyl containing compound which can be prepared by reacting a hydrocarbon-aromatic hydroxyl containing compound resin with cyanogen chloride or cyanogen bromide.

The hydrocarbon-aromatic hydroxyl containing compound resin can be prepared by reacting an unsaturated hydrocarbon or mixture of such hydrocarbons with an aromatic hydroxyl containing compound. Suitable methods as well as suitable aromatic hydroxyl containing compounds and unsaturated hydrocarbons are described in U.S. Patent 3,536,734, U.S. Patent 4,390,680, U.S. Patent 3,557,239 and U.S. Patent 4,167,542.

Particularly suitable unsaturated hydrocarbons which, either in crude or purified state, can be employed include, for example, butadiene, isoprene, piperylene, cyclopentadiene, cyclopentene, 2-methylbutene-2, cyclohexene, cyclohexadiene, methyl cyclopentadiene, dicyclopentadiene, limonene, dipentene, linear and cyclic dimers of piperylene, methyl dicyclopentadiene, dimethyl dicyclopentadiene, norbornene, norbornadiene, ethylidine norbornene and mixtures thereof. Also suitable unsaturated hydrocarbons include the other dimers, codimers, oligomers and cooligomers of the afore-mentioned unsaturated hydrocarbons. Particularly suitable unsaturated hydrocarbons which can be employed herein include, for example,a dicyclopentadiene concentrate containing from 70 to 100 percent by weight of dicyclopentadiene; from zero

to 30 percent by weight of $C_9$-$C_{12}$ dimers or codimers of $C_4$-$C_6$ dienes such as cyclopentadiene-isoprene, cyclopentadiene-piperylene, cyclopentadiene-methylcyclopentadiene, and/or dimers of isoprene, piperylene, and methyl cyclopentadiene; from zero to 7 percent by weight of $C_{14}$-$C_{18}$ trimers of $C_4$-$C_6$ dienes and from zero to 10 percent by weight of aliphatic diolefins such as piperylene, isoprene, 1,5-hexadiene and cyclic olefins such as cyclopentadiene, methyl cyclopentadiene and cyclopentene. Methods of preparations for these dicyclopentadiene concentrates and more detailed descriptions thereof can be found collectively in U.S. Patent 3,557,239 and U.S. Patent 4,167,542.

Also, particularly suitable unsaturated hydrocarbons which can be employed include a crude dicyclopentadiene stream containing from 10 to 70 percent by weight dicyclopentadiene, from 1 to 10 percent codimers and dimers of $C_4$-$C_6$ hydrocarbons (described above), from zero to 10 percent oligomers of $C_4$-$C_6$ dienes and the balance to provide 100 percent, $C_4$-$C_6$ alkanes, alkenes and dienes.

Also, particularly suitable unsaturated hydrocarbons which can be employed include a crude piperylene or isoprene stream containing from 30 to 70 percent by weight piperylene or isoprene, zero to ten percent by weight $C_9$-$C_{12}$ and codimers of $C_4$-$C_6$ dienes, and the balance to provide 100 percent by weight of $C_4$-$C_6$ alkanes, alkenes and dienes.

Also particularly suitable unsaturated hydrocarbons which can be employed include a composition comprising from 95 percent to 100 percent by weight of dicyclopentadiene and the balance, if any, to provide 100 percent by weight of $C_4$-$C_7$ saturated or unsaturated hydrocarbons or oligomers thereof.

Also, particularly suitable are hydrocarbon oligomers prepared by polymerization of the reactive components in the above hydrocarbon streams e.g., dicyclopentadiene concentrate, crude dicyclopentadiene, crude piperylene or isoprene, individually or in combination with one another or in combination with high purity diene streams.

Suitable aromatic hydroxyl-containing compounds which can be employed herein include those described in U.S. Patents 3,536,734, 3,557,239, 4,167,542 and 4,390,680. Suitable such aromatic hydroxyl-containing compounds include, for example, those compounds which contain one or two aromatic rings, at least one phenolic hydroxyl group and at least one ortho- or para-ring position with respect to a hydroxyl group available for alkylation. These and others are disclosed in the aforementioned patents.

Particularly suitable aromatic hydroxyl-containing compounds which can be employed herein include, for example, phenol, chlorophenol, bromophenol, dimethylphenol, o-cresol, m-cresol, p-cresol, hydroquinone, catechol, resorcinol, guaiacol, pyrogallol, phloroglucinol, isopropylphenol, ethylphenol, propylphenol, t-butyl-phenol, isobutylphenol, octylphenol, nonylphenol, cumylphenol, p-phenylphenol, o-phenylphenol, m-phenylphenol, Bisphenol A, dihydroxydiphenyl sulfone and mixtures thereof.

The process of reacting the unsaturated hydrocarbon with the aromatic hydroxyl-containing compound can best be conducted in two steps.

In the first step, the unsaturated hydrocarbon is fed slowly into a mixture of the aromatic hydroxyl-containing compound and a suitable catalyst at temperatures suitably from 40° C to 130° C, more suitably from 50° C to 100° C, most suitably from 60° C to 90° C for a period of time sufficient to complete the addition of the unsaturated hydrocarbon while maintaining the exothermic reaction temperature within the above stated limits, suitably from 0.25 to 8, more suitably from 0.5 to 6, most suitably from 1 to 4 hours.

Suitable Lewis acid catalysts which can be employed herein include, for example, those described in the aforementioned U.S. Patent 3,536,734 and U.S. Patent 4,390,680. Particularly suitable catalysts include, for example, $BF_3$, $AlCl_3$, $FeCl_3$, $SnCl_4$, the coordination complexes thereof, and combinations thereof.

The Lewis acid catalyst is employed in a catalytically effective amount, i.e., that amount which will sufficiently catalyze the reaction between the unsaturated hydrocarbon and the aromatic hydroxyl-containing compound at the particular reaction conditions employed. Usually, these amounts include that which provides a molar ratio of catalyst to aromatic hydroxyl-containing compound suitably from 0.002:1 to 0.1:1, more suitably from 0.003:1 to 0.05:1, most suitably from 0.003:1 to 0.01:1.

In the second step, the reaction mixture of the first step is allowed to digest at temperatures suitably from 90° C to 180° C, more suitably from 140° C to 150° C for a period of time sufficient to substantially complete the reaction between the unsaturated hydrocarbon(s) and aromatic hydroxyl-containing compound(s), suitably from 1 to 8, more suitably from 2 to 6, most suitably from 3 to 4 hours.

The unsaturated hydrocarbon and the aromatic hydroxyl-containing compound are reacted in amounts which provide a molar ratio of aromatic hydroxyl-containing compound to unsaturated hydrocarbon suitably from 1:1 to 20:1, more suitably from 2:1 to 15:1, most suitably from 3:1 to 10:1. When the molar ratio is above 20:1, reactor capacity is reduced by excess reactants and therefore effective yields are reduced. No particular advantage is seen for conducting the reaction at higher ratios. When the molar ratio is below 1:1, incomplete reaction of the unsaturated hydrocarbon will likely occur, thus preventing complete conversion of the reactants to the desired product.

The resinous product can be recovered, if desired, from the reaction mixture by simply removing the excess aromatic hydroxyl-containing compound by distillation or the like. In the preparation of cyanate resins, the reaction mass can be reacted directly, without purification, with cyanogen chloride or cyanogen bromide to produce a polycyanate resin.

The cyanate ester of the above resin prepared from one or more unsaturated hydrocarbons and one or more aromatic hydroxyl-containing compounds hereinafter referred to as unsaturated hydrocarbon/aromatic hydroxyl-containing resin can be prepared by the procedure described in U.S. Patent 4,748,270. The cyanate ester of the above unsaturated hydrocarbon/aromatic hydroxyl containing resin can also be prepared by the procedure described in U.S. 3,553,244.

The preferred compounds containing a plurality of -OCN groups are those represented by the following formula I

Formula I

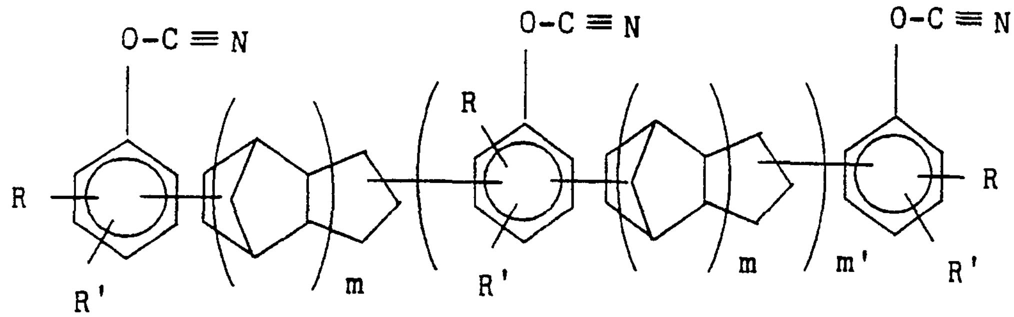

wherein each R and R′ is independently hydrogen or a hydrocarbyl or hydrocarbyloxy group having suitably from 1 to 12, more suitably from 1 to 6, most suitably from 1 to 4, carbon atoms or a halogen atom, preferably chlorine or bromine; each m independently has a value suitably from 1 to 6, more suitably from 1 to 3, most suitably from 1 to 2; and m′ has a value suitably from zero to 4, more suitably from zero to 2, most suitably from zero to 0.4.

Other suitable compounds containing a plurality of -OCN groups include those represented by the following formulas II, III and IV

Formula II

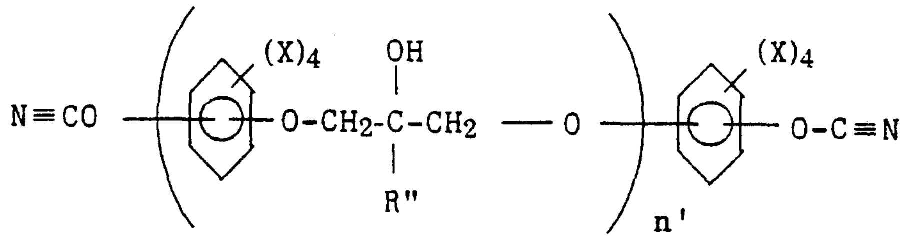

Formula III

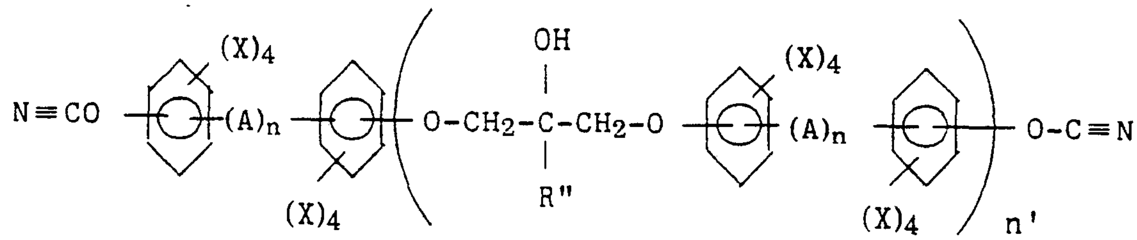

Formula IV

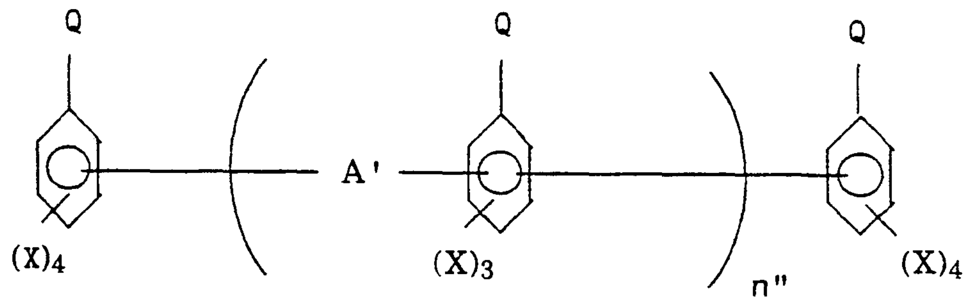

wherein each A is independently a divalent hydrocarbyl group containing suitably from 1 to 12, more suitably from 1 to 6, most suitably from 1 to 4 carbon atoms, -S-, -S-S-, -SO-, $-SO_2-$, -O-, or -CO-; each $A'$ is independently a divalent hydrocarbyl group containing suitably from 1 to 12, more suitably from 1 to 6, most suitably from 1 to 4 carbon atoms; each Q is independently a hydroxyl or -OCN group with the proviso that at least two of them are -OCN groups; $R''$ is hydrogen or an alkyl group having from 1 to 4 carbon atoms; each X is independently hydrogen or a hydrocarbyl group containing suitably from 1 to 12, more suitably from 1 to 6, most suitably from 1 to 4 carbon atoms or a halogen atom, preferably chlorine or bromine; n has a value of zero or 1; $n'$ has an average value suitably from zero to 5, more suitably from zero to 3, most suitably from zero to 2; and $n''$ has an average value suitably from 0.001 to 4, more, suitably from 0.001 to 2, most suitably from 0.001 to 1.

The term hydrocarbyl as employed herein means any aliphatic, cycloaliphatic, aromatic, aryl substituted aliphatic or cycloaliphatic, or aliphatic or cycloaliphatic substituted aromatic groups. The aliphatic groups can be saturated or unsaturated. Likewise, the term hydrocarbyloxy means a hydrocarbyl group having an oxygen linkage between it and the carbon atom to which it is attached.

Particularly suitable other cyanate ester compounds include, for example, bisphenol A dicyanate, bisphenol K dicyanate, bisphenol F dicyanate, methylene bis (3,5-dimethylphenyl-4-cyanate), 4,4′-thiodiphenylcyanate, polycyanate of phenolformaldehyde novolac resins, polycyanate of cresolformaldehyde novolac resins and combinations thereof.

The cyanate ester containing compound and the brominated styrene polymers or resins are blended in amounts which provide the resultant blend with a bromine content suitably from 4 to 25, more suitably from

8 to 15, most suitably from 10 to 14, percent bromine by weight based upon the combined weight of the cyanate containing compound and the brominated styrene polymer or resin.

Suitable curing agents for the compositions of the present invention include, for example, acids, bases, nitrogen or phosphorus compounds, transition metal salts or complexes and combinations thereof, such as metal salts of aliphatic and aromatic carboxylic acids and tertiary amines. Particularly suitable curing agents include, for example, cobalt octoate, cobalt naphthenate, cobalt acetylacetonate, zinc octoate, zinc naphthenate, tin octoate, diazobicyclo-(2,2,2)-octane, triethylamine and combinations thereof.

If desired, the compositions can be blended with other compounds such as solvents, fillers, mold release agents, pigments, dyes, flow modifiers and combinations thereof.

Suitable such solvents include, for example, halogenated hydrocarbons, aromatic hydrocarbons, cyclic ethers, amides, ketones and combinations thereof. Particularly suitable solvents include, for example, dimethylformamide, tetrahydrofuran, methylethylketone, methylene chloride and combinations thereof.

Suitable such fillers include, for example, graphite, carbon, metals, glass, natural and synthetic materials and combinations thereof in the form of, for example, matts, monofiliments, multifilaments, woven fibers, powders and rovings. Particularly suitable fillers include, glass fibers, graphite or carbon fibers and combinations thereof.

The present invention will be further described with reference to the following examples and comparative examples.

The following components are employed in the examples and comparative experiments.

Resin A is a cyanate containing resin prepared by cyanating with cyanogen chloride the reaction product of dicyclopentadiene containing three percent or less of codimers and unreactive lights and phenol, said reaction product having an average phenolic hydroxyl functionality of about 2.25 and a phenolic equivalent weight of 163 to 168. The cyanate equivalent weight is 191 (calculated).

Resin B is a brominated polystyrene resin having a bromine content of about 61.7 percent by weight, a Mw of 470,000 and a Dp of 1,700 - 2,200.

Resin C is bromostyrene monomer.

Resin D is the reaction product of vinyl benzyl chloride and tetrabromobisphenol A. The resultant vinylbenzyl ether product having a bromine content of 41.2 percent by weight.

Resin E is a brominated vinyl ester resin (60 percent non-volatiles in styrene) containing 33.3 percent bromine by weight based on non-volatiles only.

Resin F is a polycarbonate resin prepared by reacting phosgene with tetrabromobisphenol A. The resultant brominated polycarbonate has a Mw of 100,000 to 200,000 and a bromine content of 56 percent by weight.

## Example 1

### Blending of Resins

Nineteen point seven (19.7) grams of brominated polystyrene (Resin B) were dissolved in 50 ml of tetrahydrofuran. To this mixture were added 80.3 grams of a cyanate ester resin (Resin A). The mixture was placed on aluminum foil in a vacuum oven to remove the solvent. During the-first hour, the temperature was 128°C or less. The vacuum was approximately 25 inches Hg. After the first hour, the temperature varied between 128°C and 137°C. The vacuum was increased to 28 to 29 inches Hg. After a total of 2 and 2/3 hours, the resin blend was removed from the oven and allowed to cool. The resulting product contained approximately 12 percent bromine by weight.

### Casting and Curing of Resin Blend

Seventy grams of the above material were heated in a 130°C oven. To this was added 1.75 grams of a catalyst solution. The solution had been made by dissolving 0.32 gram of cobalt (III) acetylacetonate in 5 grams of divinylbenzene. The resin-catalyst blend was well mixed, then degassed under a bell jar using vacuum. The degassed material was poured into a glass mold, the internal surfaces of which had been treated with Release All #30. The mold was placed in an oven preheated to 177°C. After one hour, the temperature was raised to 225°C, followed by 2 and 1/2 hours at 250°C. This casting was tested for flammability by the UL 94 test.

Example 2

Blending of Resins

Thirteen point one (13.1) grams of brominated polystyrene (Resin B) were dissolved in 50 ml of tetrahydrofuran. To this mixture was added 86.9 grams of a cyanate ester resin (Resin A). The mixture was placed on aluminum foil in a vacuum oven to remove the solvent. During the first hour, the temperature was 128° C or less. The vacuum was approximately 25 inches Hg. After the first hour, the temperature varied between 128° C and 137° C. The vacuum was increased to 711 to 737 mmHg (28 to 29 inches Hg). After a total of 2 and 2/3 hours, the resin blend was removed from the oven and allowed to cool. The resulting product contained approximately 8 percent bromine.

Casting and Curing of Resin Blend

Seventy (70) grams of the above material were heated in a 130° C oven. To this heated mixture was added 1.75 grams of a catalyst solution. The solution had been made by dissolving 0.32 gram of cobalt (III) acetylacetonate in 5 grams of divinylbenzene. The resin-catalyst blend was well mixed, then degassed under a bell jar using vacuum. The degassed material was poured into a glass mold, the internal surfaces of which had been treated with Release All #30. The mold was placed in an oven preheated to 177° C. After one hour, the temperature was raised to 225° C, followed by 2 and 1/2 hours at 250° C. This casting was tested for flammability by the UL 94 test.

Example 3

Blending of Resins

Fifty-two point five (52.5) grams of brominated polystyrene (Resin B) were dissolved in 75 ml tetrahydrofuran (THF) This was blended into 347.5 gm of cyanate ester resin (Resin A) preheated to 90° C. The blend was placed into a vacuum oven at 115° C to 125° C for 1.75 hours under a maximum vacuum of 737 to 762 mmHg (29 to 30 in. Hg).

Casting and Curing of Resin Blend

Four point fifty-four (4.54) grams of catalyst solution was added to the blend. The solution had been made by dissolving 1.5 grams cobalt (III) acetylacetonate in 28.5 grams of divinylbenzene. The resin-catalyst blend was well mixed, then degassed under a bell jar using vacuum. The degassed material was poured into an aluminum mold, the internal surfaces of which had been treated with a 5 percent by weight solution of Dow Corning 20 silicone oil in isopropanol as a mold release agent. The mold was placed in an oven preheated to 175° C for one hour. Then the temperature was raised to 225° C for one hour, followed by 2 hours at 250° C. The physical and electrical properties of the cured product are given in Table I.

Comparative Experiment A

Six hundred (600) grams of a cyanate ester resin (Resin A) were heated in a 120° C oven. To this was added 6.8 grams of a 10 percent catalyst mixture of cobalt (III) acetylacetonate in divinylbenzene. The resin-catalyst blend was well mixed, then degassed under a bell jar using vacuum. The degassed material was poured into an aluminum mold, the internal surfaces of which have been treated with a 5 percent by weight solution of Dow Corning 20 silicone oil in isopropanol as a mold release agent. The mold was placed in an oven preheated to 100° C. After one hour, the temperature was increased to 175° C for one hour, and then the temperature was raised to 225° C for one hour, followed by 2 hours at 250° C. The physical and electrical properties of the cured product are given in Table I.

## Comparative Experiment B

### Blending of Resins

Seventy-three point three (73.3) grams of bromostyrene monomer (Resin C) were weighed into 326.7 grams of a cyanate ester resin (Resin A), preheated to 100 °C. The resulting product contained approximately 8 percent bromine.

### Casting and Curing of Resin Blend

To this heated mixture was added 4.54 grams of a catalyst solution. The catalyst solution was made by dissolving 1.5 grams of cobalt (III) acetylacetonate in 28.5 grams of divinylbenzene. The resin-catalyst blend was well mixed, then degassed under a bell jar using vacuum. The degassed material was poured into an aluminum mold, the internal surfaces of which had been treated with a 5 percent by weight solution of Dow Corning 20 silicone oil in isopropanol as a mold release agent. The mold was placed in an oven preheated to 125 °C. After one hour, the temperature was raised to 175 °C for one hour, followed by one hour at 225 °C and then 2 hours at 250 °C. The physical and electrical properties of the cured product are given in Table I.

## Comparative Experiment C

### Blending of Resins

Seventy-seven point seven (77.7) grams of the reaction product of vinyl benzyl chloride and tetrabromobisphenol A (Resin D) was blended with 329.3 grams of a cyanate ester resin (Resin A) preheated to 100 °C. The resulting product contained approximately 8 percent bromine.

### Casting and Curing of Resin Blend

To this heated mixture was added 4.54 grams of a catalyst solution. The catalyst solution was made by dissolving 1.5 grams of cobalt (III) acetylacetonate in 28.5 grams of divinylbenzene. The resin-catalyst blend was well mixed, then degassed under a bell jar using vacuum. The degassed material was poured into an aluminum mold, the internal surfaces of which had been treated with a 5 percent by weight solution of Dow Corning 20 silicone oil in isopropanol as a mold release agent. The mold was placed in an oven preheated to 175 °C. After one hour, the temperature was raised to 225 °C for one hour, followed by 2 hours at 250 °C. The physical and electrical properties of the cured product are given in Table I.

## Comparative Experiment D

### Blending of Resins

One hundred sixty (160) grams of 60 percent by weight brominated vinyl ester resin in styrene (Resin E) were blended with 304 grams of a cyanate ester resin (Resin A). The mixture was placed in a vacuum oven for 3.5 hours at 72 °C to 84 °C to remove the styrene. The vacuum was approximately 737 to 762 mmHg (29 to 30 inches Hg). The product was stored in a freezer until used. The product was transferred to a round bottom stripping flask and was stripped on a rotary evaporator at 80 °C to 85 °C under a vacuum (10 mmHg). The resulting product contained approximately 8 percent bromine.

### Casting and Curing of Resin Blend

To this heated mixture was added 4.54 grams of a catalyst solution, containing 5 percent by weight cobalt (III) acetylacetonate in divinylbenzene. The resin-catalyst blend was well mixed, then degassed on the rotary evaporator under vacuum. The degassed material was poured into an aluminum mold, the internal surfaces of which had been treated with a 5 percent by weight solution of Dow Corning 20 silicone oil in isopropanol as a mold release agent. The mold was placed in an oven preheated to 175° C. After one hour, the temperature was raised to 225° C for two hours. The physical and electrical properties of the cured product are given in Table I.

Comparative Experiment E

Blending of Resins

Fifty-seven point zero (57.0) grams of brominated polycarbonate (Resin G) were dissolved in 250 ml of tetrahydrofuran and poured into a round bottom flask containing 343 grams of a cyanate ester resin (Resin A). The mixture was heated under vacuum (8 mmHg) on a rotary evaporator at a maximum temperature of 170° C for approximately one hour. The resulting product contains approximately 8 percent bromine.

Casting and Curing of Resin Blend

The above material was then poured into an aluminum mold, the internal surfaces of which had been treated with a 5 percent by weight solution of Dow Corning 20 silicone oil in isopropanol as a mold release agent. The mold after sitting overnight at room temperature was placed in an oven preheated to 175° C. After one hour, the temperature was raised to 225° C for one hour, followed by 2 hours at 250° C. The physical and electrical properties of the cured product are given in Table I.

TABLE I

EXAMPLE OR COMPARATIVE EXPERIMENT

| PROPERTY | Ex. 1 | Ex. 2 | Ex. 3 | A* | B* | C* | D* | E* |
|---|---|---|---|---|---|---|---|---|
| Component, % by weight | A, 86.9<br>B, 13.1 | A, 80.3<br>B, 19.7 | A, 86.9<br>B, 13.1 | A, 100 | A, 81.7<br>C, 18.3 | A, 80.6<br>D, 19.4 | A, 76<br>E, 24 | A, 85.7<br>F, 14.3 |
| % Br in formulation | 8 | 12 | 8 | None | 8 | 8 | 8 | 8 |
| Flex. Str.[1] | | | | | | | | |
| psi | --- | --- | 15,846 | 17,695 | 17,613 | 16,694 | 17,860 | 18,694 |
| MPa | | | 109 | 122 | 121 | 115 | 123 | 129 |
| Flex. Mod.[2] | | | | | | | | |
| psi | --- | --- | 499,744 | 465,718 | 514,842 | 513,825 | 501,824 | 492,372 |
| MPa | | | 3,443 | 3,209 | 3,547 | 3,540 | 3,458 | 3,392 |
| Tensile Str.[3] | | | | | | | | |
| psi | --- | --- | 10,874 | 9,923 | 11,804 | 9,486 | 9,902 | 10,248 |
| MPa | | | 75 | 68 | 81 | 65 | 68 | 71 |
| Tensile Mod.[4] | | | | | | | | |
| psi | --- | --- | 466,769 | 489,918 | 501,693 | 486,040 | 472,234 | 494,343 |
| MPa | | | 3,216 | 3,376 | 3,457 | 3,349 | 3,254 | 3,406 |

TABLE I (contd.)

| PROPERTY | EXAMPLE OR COMPARATIVE EXPERIMENT | | | | | | | |
|---|---|---|---|---|---|---|---|---|
| | Ex. 1 | Ex. 2 | Ex. 3 | A* | B* | C* | D* | E* |
| % Elongation[5] | --- | --- | 3.0 | 2.2 | 3.0 | 2.3 | 2.3 | 2.7 |
| Dielect. Constant[6] Initial | --- | --- | 2.91 | 2.86 | 2.84 | 2.98 | 2.87 | 2.87 |
| After Moist. Exp.[7] | | | 3.35 | 3.47 | 3.17 | 3.85 | 3.33 | Broke[11] |
| Tg (DSC), °C[8] | --- | --- | 255 | 263 | 244 | 258 | 233 | 255 |
| Tg(TMA) °C[9] | --- | --- | 241 | 241 | 223 | 224 | 206 | 237 |
| UL 94 Flame Rating[10] | V0** | V1** | --- | --- | --- | --- | --- | --- |
| Onset of Degredation, °C[12] | --- | --- | 424.6 | 421.4 | 418.9 | 326.9 | 335.8 | 371.4 |

** This numerical rating is for comparative purposes only and is not an indication of how the composition might perform under actual fire conditions.

Footnotes to Table I

* Not an example of the present invention.

1 Flexural strength determined by ASTM D790 (1984) on 2.5 x 7.6 x 0.3 cm (1" x 3" x 1/8") coupons.

**2** Flexural modulus determined by ASTM D790 (1984) on 2.5 x 7.6 x 0.3 cm (1" x 3" x 1/8") coupons.

**3** Tensile strength determined by ASTM D638 (1984).

**4** Tensile modules determined by ASTM D638 (1984).

**5** Elongation determined by ASTM D638 (1984).

**6** Electrical properties determined on 8.6 x 7.6 x 0.3 cm (3 3/8" x 3" x 1/8") specimens. The surfaces are wiped with acetone prior to testing on a Gen Rad Precision 1689 RLC Digibridge equipped with a LD-3 specimen cell.

**7** Determined after sample is exposed in an autoclave containing a pan of water at 103.4 kPa (15 psig) and 121.1 °C (250 °F).

**8** Glass transition temperature determined by Differential Scanning Calorimetry.

**9** Glass transition temperature determined by Thermal Mechanical Analysis.

**10** Determined by Underwriters Laboratory UL 94 Flame spread test.

**11** The coupon broke before property could be determined.

**12** Onset of thermal degradation was determined by Thermal Gravimetric Analysis (TGA). Cured samples are run on a Dupont 1090 Thermal analyzer equipped with a TGA module #951 with a 20cc/min. flow of $N_2$. The temperature was increased at a rate of 10 °C/min.

## Claims

1. A cyanate ester resin blend comprising (A) at least one compound containing a plurality of -OCN groups; and (B) a brominated homopolymer or brominated interpolymer of styrene or alkyl- or halo-substituted styrene or any combination thereof; wherein components (A) and (B) are present in an amount such that the blend contains a bromine content of from 4 to 25 percent by weight based on the combined weight of components (A) and (B).

2. A blend of Claim 1 wherein component A is a polycyanate composition represented by the following formulas I, II, III or IV

Formula I

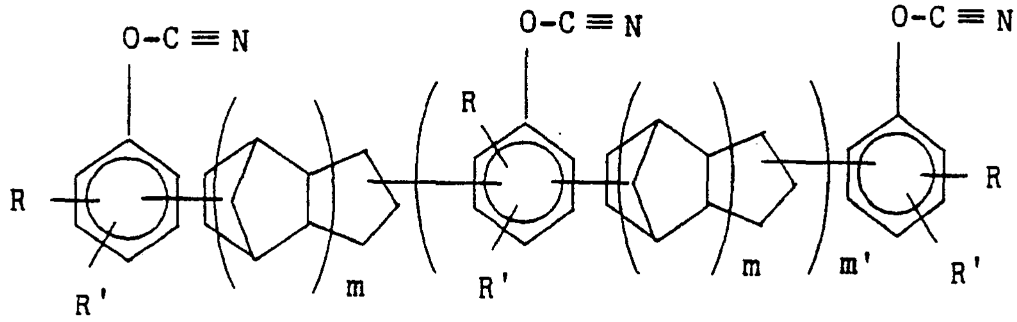

Formula II

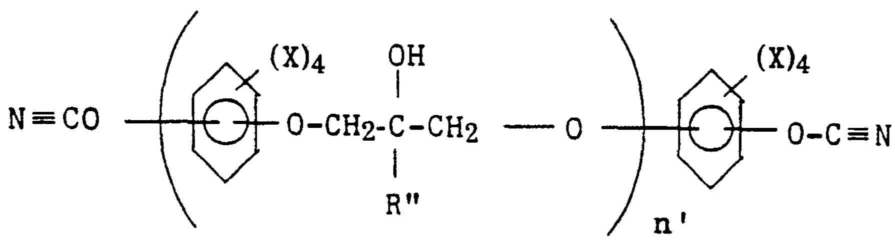

Formula III

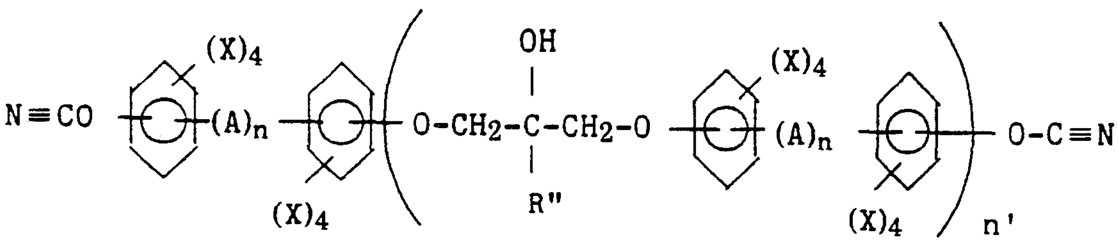

Formula IV

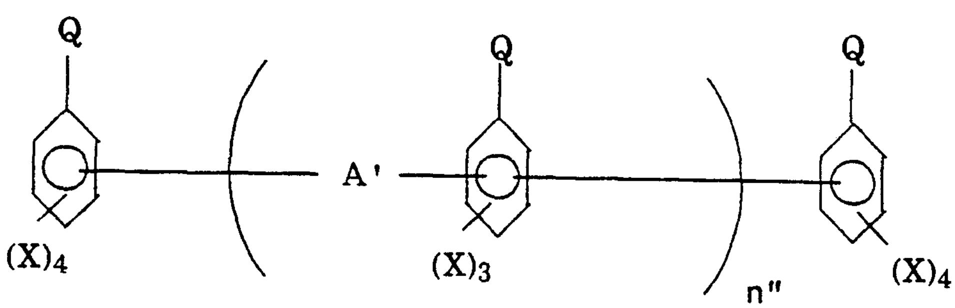

wherein each A is independently a divalent hydrocarbyl group containing from 1 to 12 carbon atoms, -S-, -S-S-, -SO-, $-SO_2-$, -O-, or -CO-; each $A'$ is independently a divalent hydrocarbyl group containing from 1 to 12 carbon atoms; each Q is independently a hydroxyl or -OCN group with the proviso that at least two of them are -OCN groups; each R and $R'$ is independently hydrogen or a hydrocarbyl or hydrocarbyloxy

group having from 1 to 12 carbon atoms; $R''$ is hydrogen or an alkyl group having from 1 to 4 carbon atoms; each X is independently hydrogen or a hydrocarbyl group containing from 1 to 12 carbon atoms; each m independently has a value from zero to 6; $m'$ has a value from zero to 4; n has a value of zero or 1; $n'$ has an average value from zero to 5; and $n''$ has an average value from 0.001 to 4.

3. A blend of Claim 1 wherein component (B) is a brominated homopolymer or brominated interpolymer of styrene, o-methylstyrene, p-methylstyrene, p-methylstyrene, 2,4-dimethylstyrene, 2,5-dimethylstyrene p-tert-butylstyrene, p-chlorostyrene, α-methylstyrene, or any combination thereof.

4. A blend of Claim 1 wherein component (B) contains from 24 to 70 percent bromine by weight; has a weight average molecular weight (Mw) of from 5,000 to 700,000; and a degree of polymerization (Dp) of from 25 to 3,000.

5. A composition of Claim 2 wherein

(a) component (A) is a cyanate containing compound represented by formula I, bisphenol A dicyanate, methylene bis (3,5 dimethylphenyl-4-cyanate) or 4,4′-thiodiphenylcyanate; and

(b) component (B) is brominated polystyrene.

6. A composition of Claim 1 wherein component (A) is a cyanated dicyclopentadiene-phenol resin.

7. A curable composition comprising a blend of Claim 1 and a curing amount of at least one curing agent therefor.

8. An article resulting from curing a composition of Claim 7.